# EUROPEAN PATENT APPLICATION

(11) **EP 2 945 035 A1**
(43) Date of publication of application: **18.11.2015**
(21) Application number: 15164116.4
(22) Date of filing: 17.04.2015
(51) Int. Cl.: G05B 23/02

(54) **METHOD AND SYSTEM FOR DETECTING AND LOCATING ONE OR MORE WIRING DEFECT IN DEDICATED AIRCRAFT SYSTEMS**

(30) Priority: 14.05.2014 US 201461993148 P; 11.12.2014 US 201414567705
(71) Applicant: Airbus (S.A.S.), 31700 Blagnac (FR)
(72) Inventor: Barre, Jean-Luc, 31770 Colomiers (FR); Catoire, Benjamin, 31200 Toulouse (FR); Saissi, Laurent, 31370 Poucharramet (FR); Bel, Joana, 31400 Toulouse (FR)
(74) Representative: Gicquel, Olivier Yves Gérard

(57) **Abstract**

A method is disclosed for detecting and locating one or more wiring defect in at least one dedicated system (106) of an aircraft, for example and without limitation, using a system testing tool (100) to detect and locate one or more wiring defect in at least one dedicated system of an aircraft. In some aspects, the method includes using the system testing tool for generating data from the at least one system of the aircraft. In addition, the method also includes using the system testing tool (100) for comparing the data with equivalent reference data, as well as for automatically detecting a presence or an absence of one or more wiring defect in the at least one system of the aircraft. Where one or more wiring defect is present in the at least one system, the system testing tool automatically locates the one or more wiring defect

## Description

The subject matter described herein relates generally to wiring checking in aircrafts. More particularly, the subject matter disclosed herein relates to methods and systems for detecting and locating wiring defects in dedicated aircraft systems.

Wiring checks are a challenge for airline operators and aircraft manufacturers due to the numerous permanent defects (e.g., open circuits, short circuits, bounding issues, grounding issues, etc.) or intermittent defects (e.g., contaminated connector pins, insulation scratches, etc.) on wires that may appear anywhere in an electrical wiring system. Detecting and locating such defects is also challenging due, in part, to the length of the wires, the number of wires to be tested, the different types of wires, the different materials used for each wire, etc. Added to these technical difficulties is the frequency to which these issues are encountered, as there may be many events a year, of which some cases may need on-site assistance from the aircraft manufacturers. As a result, airline operators and aircraft manufacturers spend a large amount of time and resources in completing wiring checks, which in turn results in significant costs for the airline operators and/or the aircraft manufacturers.

Accordingly, there exists a need for method and system for detecting and locating wiring defects in dedicated aircraft systems, in order to complete wiring checks in a timely and cost-effective manner.

The invention concerns a method according to claim 1 and a system according to claim 4 that address this need.

The subject matter described herein will now be explained with reference to the accompanying drawings, of which:
Figure 1 is a perspective view illustrating an exemplary aircraft according to an embodiment of the subject matter described herein;
Figure 2 is a diagram illustrating an exemplary system testing tool for detecting and locating one or more wiring defect in at least one dedicated aircraft system under test;
Figure 3 is an exemplary wire characteristics measurement electrical image illustrating equivalent reference data generated from another aircraft system that is devoid of one or more wiring defect;
Figure 4 is an exemplary distance-to-fault measurement electrical image illustrating equivalent reference data generated from another aircraft system that is devoid of one or more wiring defect;
Figure 5 is a diagram illustrating exemplary measurement tolerances of equivalent reference data generated from another aircraft system that is devoid of one or more wiring defect;
Figure 6 is an exemplary wire characteristics measurement electrical image illustrating detection of a wiring defect in at least one dedicated aircraft system under test through a comparison between data generated from the dedicated aircraft system under test with equivalent reference data generated from another aircraft system that is devoid of one or more wiring defect;
Figure 7 is an exemplary distance-to-fault measurement electrical image illustrating location of a wiring defect in at least one dedicated aircraft system under test through a comparison between data generated from the dedicated aircraft system under test with equivalent reference data generated from another aircraft system that is devoid of one or more wiring defect; and
Figure 8 is a diagram illustrating an exemplary process for detecting and locating one or more wiring defect in at least one dedicated aircraft system under test according to an embodiment of the subject matter described herein.

In accordance with the description herein and exemplary, associated drawings, a method and a system tool are disclosed for detecting and locating one or more wiring defect in dedicated aircraft systems. Such method and system optimize aircraft availability by reducing aircraft-on-ground (AOG) or out-of-service situations, reducing time needed to detect and locate a wiring defect, reducing rate of fault reoccurrence, reducing unnecessary equipment removal, and reducing costs.

Reference will now be made in detail to exemplary embodiments of the subject matter described herein, examples of which are illustrated in the accompanying drawings. Wherever possible, the same reference numbers will be used throughout the drawings to refer to the same or like parts.

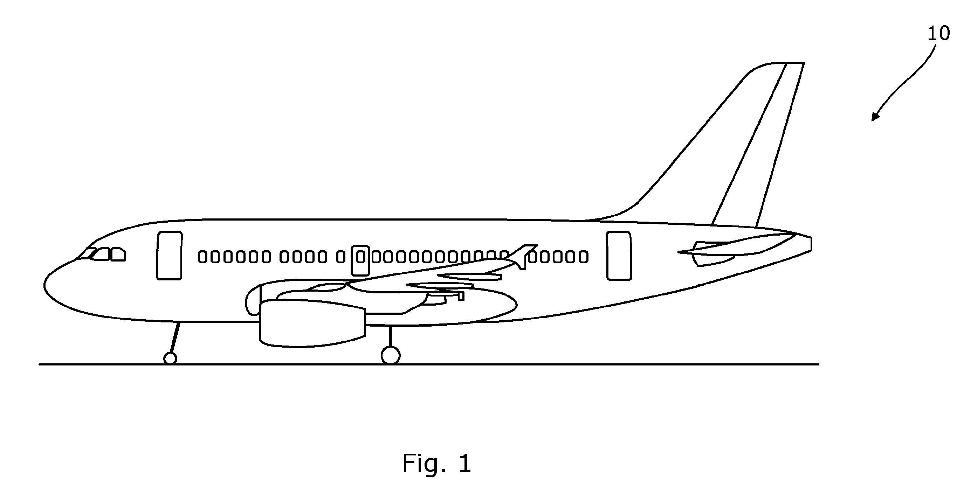

Figure 1 is a perspective view illustrating an exemplary aircraft **10** according to an embodiment of the subject matter described herein. Aircraft **10** comprises at least one wiring system undergoing a wiring check using the systems, methods, and computer readable media described in the following.

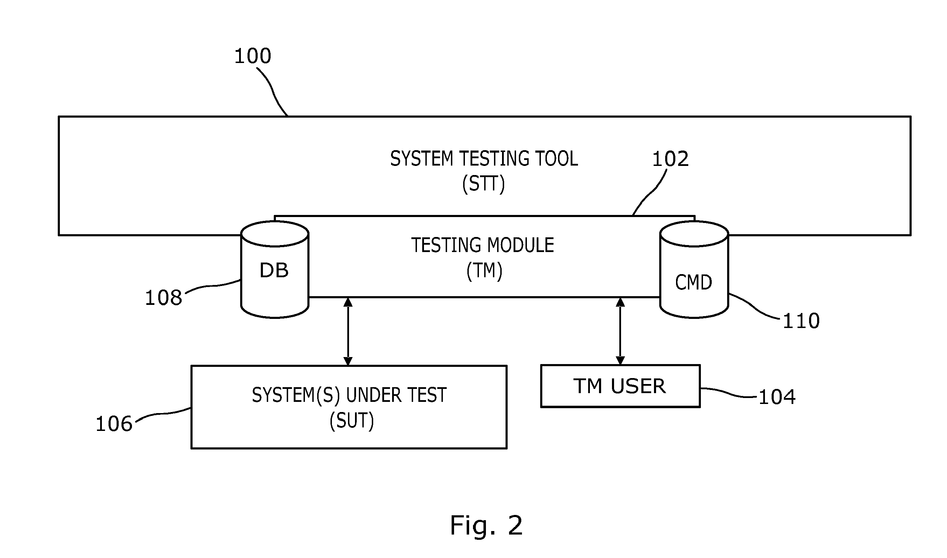

Figure 2 is a diagram illustrating an exemplary computing platform or system testing tool (STT) **100** for detecting and locating one or more wiring defect in aircraft **10.** STT **100** represents any suitable entity or entities (e.g., a testing platform or a server farm) for performing a wiring check in at least one dedicated system of aircraft **10.** Performing a wiring check comprises automatically detecting, locating, and/or identifying a presence or an absence of one or more wiring defect in at least one system being tested. Where the presence of one or more wiring defect is found, STT **100** detects and is configured to locate the one or more wiring defect(s) in the system being tested of aircraft **10.**

In some aspects, STT **100** is a stand-alone tool, a testing device, or software executing on a processor. In some embodiments, STT **100** is a single node or is distributed across multiple computing platforms or nodes. In some aspects, STT **100** replaces another component of aircraft **10,** for e.g., a control unit, in order to test a designated system. For example, STT **100** is a stand-alone device (e.g., a wiring defect detection device) that is connected to the ARINC connector for a dedicated system under test (SUT) **106** in order to check wiring in SUT **106** for both permanent defects and/or intermittent defects, where up to 512 wires are present in SUT **106.** SUT **106** in one aspect is any dedicated system or systems within aircraft **100.**

In some aspects, permanent defects comprise, for example, open circuits, short circuits, bounding issues, grounding issues, etc., while intermittent defects comprise, for example, contaminated connector pins, twisted wire, shielded twisted wire, etc. STT **100** detects and is configured to detect both types of defects in dedicated systems, where detecting a permanent defect may take less than two hours, while detecting an intermittent defect may take less than one day. Once STT **100** has detected and located one or more defect, it is relatively easy for an engineer or another associated user, to remove only necessary access panel(s) above which the one or more wiring defect is located. This saves time, while also preventing any inadvertent equipment damage.

STT **100** includes a testing module (TM) **102.** TM **102** may be any suitable entity (e.g., software executing on a processor) for performing one or more aspects associated with checking the wiring in dedicated aircraft systems. TM **102** includes functionality for automatically detecting and/or locating one or more wiring defect in at least one SUT **106** by running a test script. For example, a test script in one aspect is a transcription of test protocol prepared and/or validated by a manufacturer of aircraft **10,** an operator of aircraft **10,** or another third party entity associated with aircraft **10.** In one non-limiting example, a test protocol is prepared by customer support engineering staff and validated by design office staff. However, any manufacturer, operator, or third party entity associated with aircraft **10** prepares and/or validates the test protocol.

In some aspects, preparing the test protocol comprises an entity (e.g., a customer support engineering staff member) accessing and acquiring data containing information related to preparing test protocol (e.g., lists, test signals, configurations, procedures, validations, certifications, etc.) from data storage. Exemplary data storage may include non-transitory computer readable media, such as flash memory, random access memory, or other storage devices. In some aspects, data storage is external to and/or or integrated with STT **100** and/or TM **102.** For example, an entity preparing the test protocol may access and acquire data stored in a database **108,** which in one aspect contains configuration information regarding aircraft **10.** Database **108** is associated with TM **102** and/or STT **100,** and comprises data regarding an initial analysis of the faulty system or SUT **106** of aircraft **10** in terms of end-users installed and electrical configuration (e.g., cable types, wiring routing, etc.). Database **108** may also comprise dedicated test signals that are be defined for each line to be tested (e.g. voltage, current, frequency, duration, etc.) in SUT **106.** The entity preparing the test protocol additionally may access and acquire a list of each piece of end-user equipment installed in aircraft **10,** validation from an entity (which may be the same as or different than the entity preparing the test protocol) that STT **100** will not damage each piece of end-user equipment installed. This information is obtainable from database **108** or from other data storage in communication with TM **102** and/or STT **100.**

In some aspects, validating the test protocol comprises an entity (e.g., a design office staff member) reviewing the prepared test protocol. The validating entity may be the same as or different than the entity validating the test protocol and reviews the test protocol to ensure that the tests are performed with the right procedure, the right testing signals (proof-reading), etc. Once the test protocol is validated by the validating entity, the test protocol is transcribed into the test script to be automatically run by TM **102** on SUT **106.**

In addition to providing functionality for automatically detecting and/or locating one or more wiring defect in at least one SUT **106** by running the test script, TM **102** in one aspect includes functionality for storing the test script for future use. For example, TM **102** comprises a configuration management database (CMD) **110** that includes the functionality for storing the test script for future use and providing access for TM **102,** as well as other mfdules, to retrieve the stored test script. CMD **110** includes non-transitory computer readable media, such as flash memory, random access memory, or other storage devices. In some aspects, CMD **110** is external to and/or or integrated with STT **100** and/or TM **102.** In other aspects, CMD **110** s configured as both CMD **110** and database **108,** such that the configuration information regarding aircraft **10** is also accessibly stored in CMD **110.** In the non-limiting example of Figure 2, CMD **110** and database **108** are depicted as two separate storage devices. However, CMD **110** and database **108** may be one and the same.

In some aspects, TM **102** includes one or more communications interfaces for interacting with users and/or nodes. For example, TM **102** provides a communication interface for communicating with a TM user **104.** In some aspects, TM user **104** is an automated system or is controlled or controllable by a human user. For example, TM user **104** connects and/or configures STT **100** with regard to SUT **106.** In some aspects, TM **102** is configured to generate and display content (e.g., electrical images) associated with SUT **106** after STT **100** is installed and connected with SUT **106.** For example, where STT **100** is a stand-alone device, STT **100** comprises at least one set-up connection harness that TM user **104** installs with SUT **106.** In some aspects, installing STT **100** requires removal of a control unit (not shown) with STT **100** and replacement with STT **100** by a TM user **104.** Personnel other than TM user **104** may also be tasked with installing STT **100.** Thus, TM **102** includes one or more interfaces for interacting with one or more SUT **106.**

After STT **100** is installed or connected to SUT **106,** TM **102** is configured to run the test script in order to detect and/or locate one or more wiring defect in SUT **106.** For example, TM **102** comprises the functionality to simultaneously detect and/or locate one or more wiring defect in all lines of SUT **106.** In some instances, SUT **106** has 512 lines. Thus, TM **102** is configurable to simultaneously test 512 lines of SUT **106,** although each SUT **106** may have more or less lines. TM **102** is configured to access the test script that is stored in CMD **110.** The test script comprises the test protocol prepared and validated by an entity or entities, such as, for example, the manufacturer, operator, or another third party associated with aircraft **10.** When TM **102** runs the test script, the test script provides the functionality to generate electrical images of SUT **106.** The electrical images generated by TM **102** running the test script provide data to be used in detecting and locating one or more fault or defect in the wiring lines of SUT **106.**

Once the electrical images are generated, the generated electrical image feedback is read by an interested party or parties (e.g., TM user **104,** service engineers, etc.) via a display interface, which may or may not be provided with STT **100,** and/or TM **102.** In one aspect, for example, the display interface is integral to STT **100,** while in another aspect, for example, the display interface is a component of aircraft **10** or another component remote to aircraft **10.** Where the display interface is configured as a component separate from STT **100,** STT **100** in one aspect is configured to communicate the generated electrical image feedback to a different device to be uploaded and subsequently displayed. In some aspects, the display interface comprises a user interface (not shown) that allows a user to interact with the data provided by the electrical image feedback.

TM **102** also provides the functionality of recording or storing the generated electrical images in a data storage device in order to track the different wiring configurations of each line of SUT **106.** For example, CMD **110** in one aspect is configured to record or store the electrical images generated by TM **102** running the test script, in addition to storing the test script, itself. Alternatively, for example, the generated electrical images are recorded or stored in a storage device, other than CMD **110,** that is accessible by STT **100.** Where the generated electrical images are recorded or stored in a storage device other than CMD **110,** the other storage device is configured to communicate the stored data with one or both of STT **100** and TM **102.** In one aspect for example, the storage device (whether it is CMD **110** or another storage device) has an architecture for storing the generated electrical images that comprises:
ATA chapter > Systems specificities > MSN > Operator > Recording date, where the system specificities comprise optional parts, etc.

In some aspects, both permanent defects and intermittent defects are able to be detected and located using electrical images generated by TM **102,** while, conversely, the electrical images generated by TM **102** also detect the absence of any defects in SUT **106.** Typically, intermittent defects are less common, but are harder to detect and locate. This is because some intermittent defects have a fault duration greater than one millisecond.

In some exemplary embodiments, the generated electrical images comprise wire characteristics measurements for each line of SUT **106.** For example, TM **102** in one aspect comprises a wire characteristics measurement module that runs the test script and generates wire characteristics measurement electrical images. In some aspects, the wire characteristics measurement electrical images are RLC measurements of SUT **106.** RLC measurements measure different types of wirings and equipment in SUT **106** using different signals or pulses. For example, when the wire characteristics measurement module runs the test script, the test script is configured to inject a continuous signal or pulse, or a series of signals or pulses down each line of SUT **106.** The reflected signal or pulse along each line of SUT **106** is observed in the form of a wire characteristics measurement electrical image.

The wire characteristics measurement electrical image consists of data values for a variety of characteristics being measured by signals or pulses for each line of the system under test. For example, the characteristics include resistance, capacitance, inductance, voltage, frequency, etc., where each characteristic has a defined, standard unit of measurement. In addition, the wire characteristics measurement electrical image includes locations of the high point and/or the low point for each line of the system under test. The wire characteristics measurement electrical image is configured to display in a table format using a display interface that is easily viewable and discernable to a user. A user interface is configured to allow a user, (e.g., TM user **104**) to select and view individual, or a select number, of wire characteristics measurements for each line of the system under test. Other user interactions with the wire characteristics measurement electrical image are also contemplated.

In some exemplary embodiments, the electrical images comprise distance-to-fault measurements for each line of the system under test. For example, TM **102** comprises a distance-to-fault measurement module that runs the test script and generates distance-to-fault measurement electrical images. The distance-to-fault measurement electrical images in one aspect consist of a graphical representation of amplitude versus direction for each line of the system under test. In some aspects, the distance-to-fault electrical images of the system under test are reflectometric images of the system. The reflectometric images identify the locations of one or more fault or defect in the wiring of the system under test, where such fault(s) or defect(s) are present, by observing reflected signals or pulses at the wiring interface(s). For example, when the distance-to-fault measurement module runs the test script, the test script is configured to inject a continuous signal or pulse, or a series of signals or pulses down each line of the system under test. The reflected signal or pulse along each line of the system under test is observed in the form of a distance-to-fault measurement electrical image. The location(s) of one or more different defect or fault are observed based on the injected signal or pulse, where such fault(s) or defect(s) are present.

In some aspects, the distance-to-fault measurement electrical image measures and integrates the strength of the return signals or pulses as a function of time in order to plot the line length (distance) for each line of the system under test versus the amplitude of the pulse or signal (amplitude). The amplitude versus distance plot includes data values illustrating significant spike(s) in amplitude. Significant spikes in amplitude are representative of a disruption in the line, whether this disruption is merely a connector, pins, interfaces, etc., or is one or more defect, fault, etc., along each line of the system under test. Determination of what the spike in amplitude is representative of may be dependent on the application of TM **102.** For example, where TM **102** is used for merely collecting reference data from a wiring system that is known or be devoid of defects or "healthy", any spike in amplitude would be representative of a "healthy" disruption or a connector, pin, interface, etc. disposed along the line at an expected location. In comparison, where TM **102** is used on a wiring system that is known to have a defect or suspected of having one or more wiring defect, a spike in amplitude could be representative of either a "healthy" disruption or a defect. Determination of what the spike represents in such a situation will be discussed in further detail below. Thus, the distance-to-fault measurement electrical image provides the location at which any disruptions are located along each line of the system under the test.

Accordingly, in order to automatically detect a presence or an absence of one or more fault in SUT **106** of aircraft **10,** the test script is first run on an identical dedicated system of an aircraft devoid of defects or "healthy", such as, for e.g., an aircraft in final assembly. The test script is run on the healthy aircraft system using a testing device and/or module similar to STT **100** and TM **102,** which communicates with and access the test script stored in CMD **100.** For example, the test script is accessed via a network from CMD **110.** Alternately, the system testing tool is STT **100.**

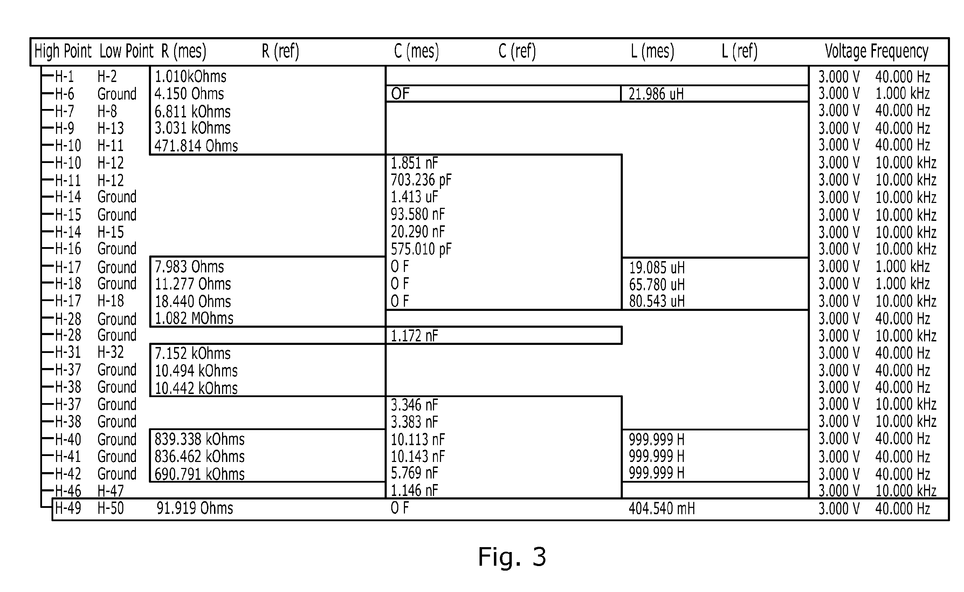

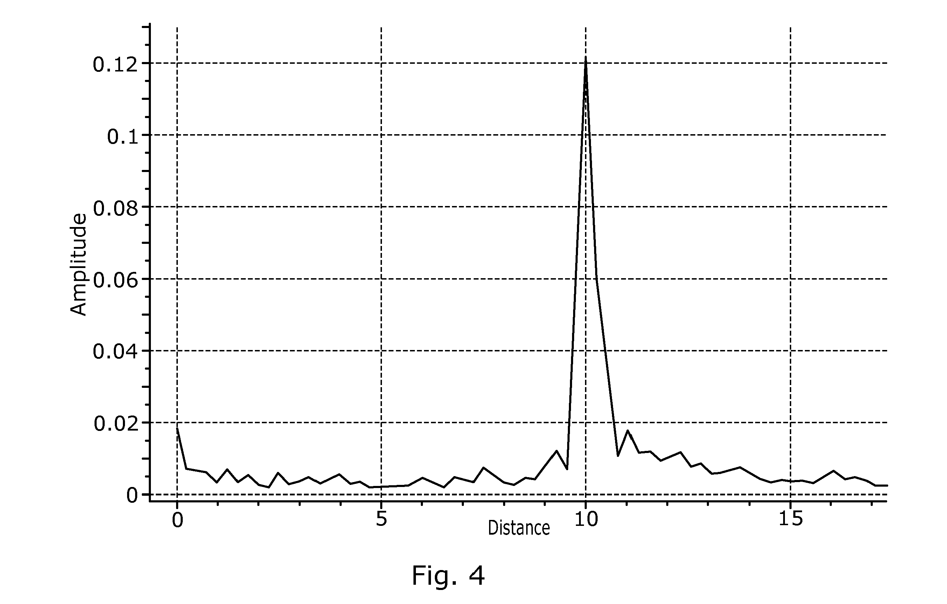

The procedure for running the test script on the identical system in the healthy aircraft requires a test module, such as TM **102,** or a test module other than TM **102,** to access the test script from storage in CMD **110.** The test module, TM **102** or otherwise is configured to run the test script in order to generate electrical images of the identical system. For example, a wire characteristics measurement electrical image and/or a distance-to-fault measurement electrical image is generated by the testing module, which provides reference data of an ideally healthy aircraft system. Figure 3 illustrates an exemplary reference wire characteristics measurement electrical image of a system of the healthy aircraft, while Figure 4 illustrates an exemplary reference distance-to-fault measurement electrical image of the same system of the healthy aircraft. As seen in Figure 4, an amplitude spike at 10 meters along a line (i.e., High Point: J21-4; Low Point: Ground) is representative of a "healthy" disruption, e.g., connector, pin, interface, etc. For example, in Figure 4, the spike is indicative of a connector located 10 meters along the line. These exemplary reference electrical images are generated and stored in CMD **110** or another data storage that communicates with and is accessible by STT **100** and/or TM **102.**

In comparison with generating reference electrical images of the identical system of the healthy aircraft, generating the electrical images of SUT **106** comprises, for example, simultaneously recording the electrical images in CMD **110** and comparing, in real time and without a delay, the generated electrical images against the system configuration stored in database **108.** More specifically, TM **102** accesses the system configuration measurements and/or data stored in database **108** and compares those configuration measurements against the real time generation of the electrical images of SUT **106.** In some embodiments, recording the electrical images in CMD **110** does not need to be simultaneously accomplished with comparing, in real time and without a delay, the generated electrical images against the system configuration stored in database **108.**

Once the test script has been run and electrical images have been generated of the identical system of the healthy aircraft, TM **102** compares the electrical images of SUT **106** with the equivalent reference electrical images. Both sets of electrical images are accessed from DMB **110** or another database where the electrical images are stored in order for analysis to be performed. By comparing the electrical images generated by running the test script on SUT **106** against the equivalent reference electrical images, STT **100** highlights a presence or an absence of any potentially faulty system lines based on previously defined tolerances for each tested line.

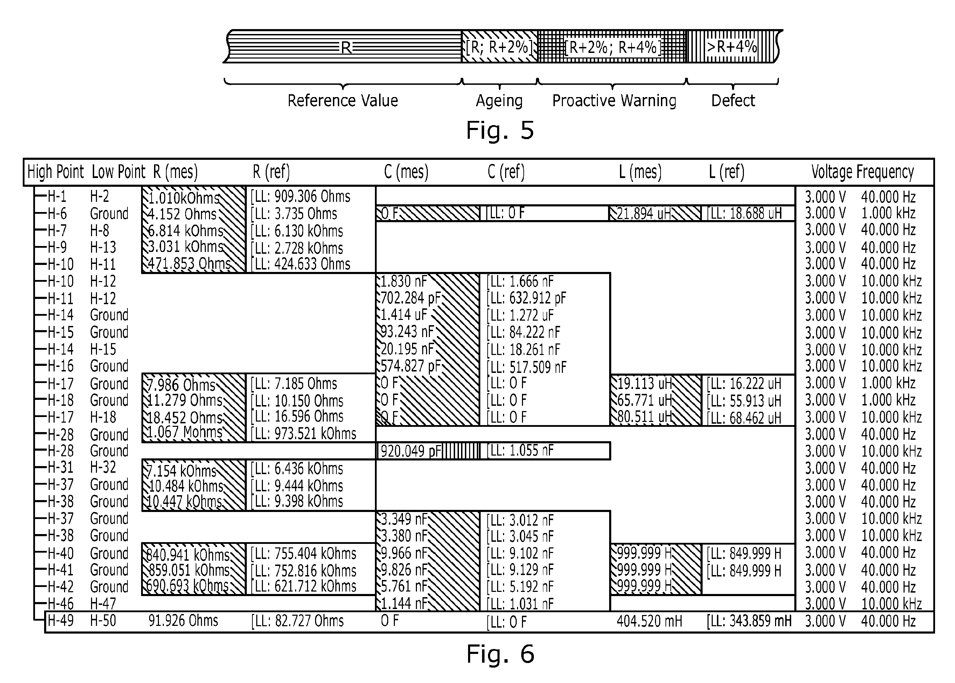

In some aspects, the tolerance for each system line is different, such that some lines may have higher tolerances than other lines. For example, Figure 5 illustrates an exemplary implementation of measurement tolerances to be used in comparing the electrical images generated by running the test script on SUT **106** against the equivalent reference electrical images. In Figure 5, a reference value **R** is defined based on the measurements and/or data collected from the equivalent reference electrical images. Any deviations from the reference value are categorized based on the extent of the deviation. This allows STT **100** to be used in a proactive manner by labeling any tolerance deviations based on the extent of the deviation. For example, very slight deviations (e.g., [**R; R+2%**] are categorized as merely ageing wires, in which case, the absence of a defect is noted by a comparison of the equivalent reference value to the value obtained from SUT **106.** Deviations that are more substantial (e.g., [**R+2%; R+4%**]) are categorized as a proactive warning, in order to alert TM user **104** of wires in which one or more defects may be occurring in the near future, in which case, the absence of a defect is noted by a comparison of the equivalent reference value to the value obtained from SUT **106.** Substantial deviations (e.g., [**>R+4%**]) are categorized as defects or faults, and are indicated as defects in the analysis. Please note that these tolerances in Figure 5 are exemplary only, and other deviation percentages may be used by STT **100** when comparing the equivalent reference value to the value obtained from SUT **106.** Further, different colors, hatching, etc. may be used when displaying on the display interface the values obtained from SUT **106** in order to provide clearly discernable information regarding the presence or absence of one or more wiring defect.

As a result, TM **102** detects and locates one or more defect or fault in SUT **106** by analyzing whether measurements or data of a certain line of SUT **106** are within the tolerances defined for the identical system of the healthy aircraft. For example, wire characteristics measurement results and/or distance-to-fault measurement results are generated by TM **102,** which provides a comparison of each line of SUT **106** against the equivalent reference data of each line of an ideally healthy aircraft system. Figure 6 illustrates an exemplary wire characteristics measurement result for SUT **106,** where the equivalent reference data for each line of the identical system of the healthy aircraft is also displayed for easy comparison. As illustrated in Figure 6, a fault is indicated by distinct, vertical hatching at a line (i.e., High Point: H-28; Low Point: Ground) of SUT **106,** where the capacitance, measured in Farads (F), is measured as 920.049 pF, while the reference measurement at that line in the identical system of the healthy aircraft is measured as 1.055 nF. Following the tolerance measurement standard illustrated in Figure 5, it is apparent that the measurement at line H-28 in SUT **106** of 920.049 pF is greater than 0.4% of the equivalent reference value of 1.055 nF measured in the identical system of the healthy aircraft. Accordingly, the wire characteristics measurement results recorded by TM **102** indicate the existence of one or more fault or defect in said line of SUT **106.**

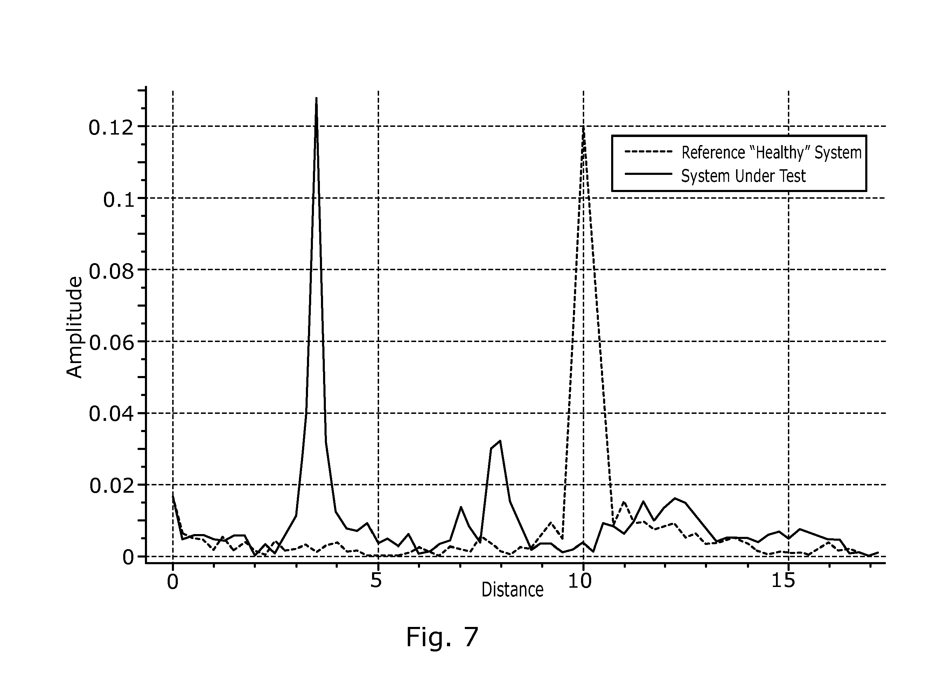

Figure 7 illustrates exemplary distance-to-fault measurement electrical image results of a line of SUT **106,** where the corresponding line of the identical system of the healthy aircraft is also illustrated for comparison purposes. As seen in Figure 7, an amplitude spike at 10 meters along the healthy line (i.e., High Point: J21-4; Low Point: Ground) is representative of a "healthy" disruption, e.g., connector, pin, interface, etc. (See, Fig. 4). By comparison, in Figure 7, an amplitude spike occurs at 3.5 meters along the equivalent line in SUT **106,** rather than at 10 meters. Since the reference data indicates that a spike should only occur at 10 meters alone the line, this spike in the line of SUT **106** is representative of a defect located 3.5 meters. For example, this defect comprises a pin not being properly inserted or crimped. Accordingly, the distance-to-fault measurement electrical image results enable a technician or engineer to quickly locate the aircraft panel at which the 3.5 meter mark of the line represented in Figure 7 resides and remedy the defect by replacing the pin, repairing the wire, etc.

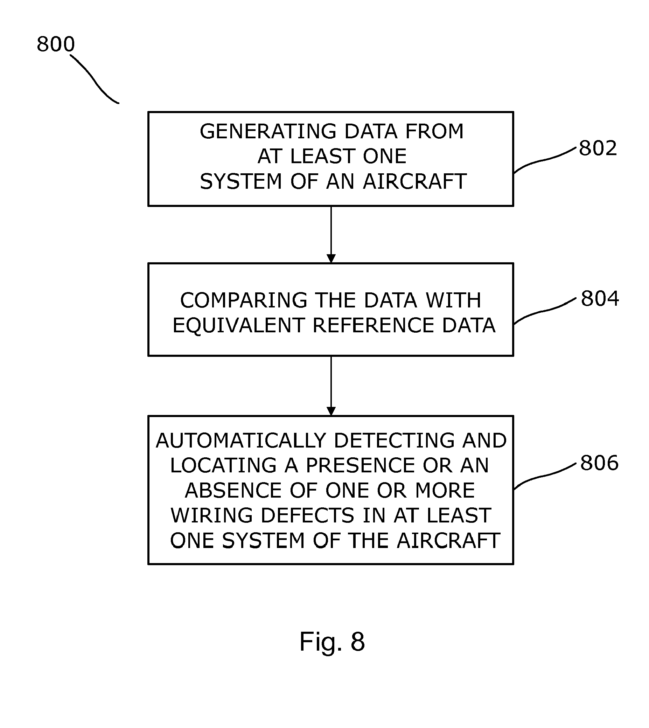

Figure 8 is a diagram illustrating an exemplary process for detecting and locating one or more wiring defect in at least one dedicated aircraft system, according to an embodiment of the subject matter described herein. In some embodiments, exemplary process **800,** or portions thereof, are performed by or at computing platform **100** (e.g., a system testing tool), TM **102,** and/or another node or module.

At step **802,** data is generated from a system under test or SUT **106.** For example, a STT **100** or TM **102** generates data from SUT **106.** In some aspects, the data generated from SUT **106** comprises electrical images, such as, for example, wire characteristics measurement electrical images and/or distance-to-fault measurement electrical images. The wire characteristics measurement electrical images are, in some embodiments, RLC measurement images, while the distance-to-fault measurement electrical images are, in some embodiments, reflectometric images.

In some embodiments, generating the data further comprises comparing in real time the data generated from SUT **106** to a system configuration of SUT **106.**

In some embodiments, the data from SUT **106** is generated by STT **100** and or TM **102** launching a test script to run a test, where the test script generates the data from SUT **106.**

At step **804,** the generated data is compared with equivalent reference data. For example, STT **100** or TM **102** compares the data generated from SUT **106** against reference data generated from an equivalent system of another aircraft. In some aspects, the other aircraft is a "healthy" aircraft or one with an equivalent system(s) devoid of any defect. In some embodiments, the equivalent reference data comprises electrical images, such as, for example, wire characteristics measurement electrical images and/or distance-to-fault measurement electrical images. The wire characteristics measurement electrical images are, in some embodiments, RLC measurement images, while the distance-to-fault measurement electrical images are, in some embodiments, reflectometric images.

In some embodiments, the equivalent reference data is generated by STT **100** TM **102** or another computing platform and/or module, launching a test script to run a test, where the test script generates the reference data from the "healthy aircraft".

In some embodiments, the generated data from SUT **106** and/or the equivalent reference data is stored in at least one storage database. Similarly, the generated data from SUT **106** and/or the equivalent reference data is retrieved from the at least one storage database in order to compare the generated data from SUT **106** with the equivalent reference data.

At step **806,** automatic detection and/or location of a presence or an absence of one or more wiring defect in the at least one system of aircraft **10** occurs. For example, STT **100** and/or TM **102** automatically detects the presence or the absence of one or more wiring defect in SUT **106** by analyzing the comparison of the data generated from SUT **106** with the equivalent reference data (i.e., step **804**). In some embodiments, the equivalent reference data comprises predetermined tolerance values, such that the presence of the one or more detected wiring defect in SUT **106** results in the generated data falling outside the predetermined tolerance values. Conversely the absence of one or more defect results in the generated data falling within the predetermined tolerance values. For example, where the generated data comprises wire characteristics electrical image(s), the image(s) detects the presence or the absence of one or more defect along a line.

In some embodiments, where there is a presence of one or more wiring defect in SUT **106,** STT **100** automatically detects and locates the one or more wiring defect in SUT **106** using the generated data. For example, where the generated data comprises distance-to-fault electrical image(s), these image(s) provide a location for any defect along a line on which the defect is present.

## Claims

1. A method for detecting and locating one or more wiring defect in at least one dedicated system (106) of an aircraft (10), the method comprising the steps of:
injecting, via a system tool (100) launching a test script for testing the dedicated system, a continuous signal or pulse, or a series of signals or pulses down each electrical line of the dedicated system under test;
analyzing, by the system tool (100), the reflected signal or pulse along each line of the system under test;
generating (802), by the system tool (100), data from each line of the system under test, said data being in the form of a distance-to-fault measurement electrical image;
comparing (804), by the system tool (100), for each electrical line of the dedicated system under test, the generated data with equivalent reference data, **characterized in that** the equivalent reference data is from an aircraft dedicated system devoid of any defects; and
automatically detecting (806), by the system tool (100), a presence or an absence of one or more wiring defect in each electrical line of the dedicated system under test, automatically detecting (806) the presence or the absence of the one or more wiring defect comprising automatically locating the one or more wiring defect, where the one or more wiring defect is present in the at least one dedicated system.

2. A method according to claim 1, further comprising storing the generated data from the at least one dedicated system (106) and the equivalent reference data in at least one storage database, **characterized in that** comparing the data with the equivalent reference data comprises retrieving the equivalent reference data and the generated data from the at least one storage database.

3. A method according to any one of the claims 1 to 2, wherein generating data from the at least one dedicated system of the aircraft comprises comparing in real time the data generated from the at least one dedicated system (106) to a system configuration of the at least one dedicated system.

4. An system tool (100) for detecting and locating one or more wiring defect in an aircraft, **characterized in that** the system tool (100) is configured to implement the method according to claims 1 to 3 for detecting and locating one or more wiring defect in at least one dedicated system (106) of the aircraft (10),
